# EUROPEAN PATENT APPLICATION

(11) **EP 4 415 206 A1**
(43) Date of publication of application: **14.08.2024**
(21) Application number: 23155914.7
(22) Date of filing: 09.02.2023
(51) Int. Cl.: H02J 7/00, H02M 7/483

(54) **AN ENERGY STORAGE SEGMENT FOR AN ENERGY STORAGE SYSTEM AND A METHOD FOR CONTROLLING AN ENERGY STORAGE SYSTEM**

(71) Applicant: Hitachi Energy Ltd, 8050 Zürich (CH)
(72) Inventor: Viatkin, Aleksandr, 722 20 Västerås (SE); Bakas, Panagiotis, 72212 Västerås (SE); Zhang, Zichi, 723 58 Västerås (SE); Bai, Haofeng, 723 48 Västerås (SE)
(74) Representative: AWA Sweden AB

(57) **Abstract**

There is disclosed herein an energy storage segment (10) for an energy storage system (1). The energy storage segment comprises a first terminal (40) and a second terminal (42), a plurality of energy module circuits (11) connected in parallel between a first busbar (50) and a second busbar (52). The second busbar is connected to the second terminal. Each energy module circuit (11) comprises an energy storage module (12) and a module switch (14) connected in series. The energy storage segment further comprises a first half bridge switch unit (20) connected between the first terminal and the first busbar and in series with the plurality of energy module circuits (12) and a second half bridge switch unit (30) connected between the first terminal and the second terminal. The disclosure further relates to an energy storage system (1) and a method (100) for controlling said energy storage system.

## Description

### Technical field

The present disclosure relates to an energy storage segment and a method for controlling an energy storage system.

### Background

Energy storage systems, such as for example batteries, super capacitors and fuel cells, are used in power grids to store excess energy that is generated during times when demand is low, and then release that energy back into the grid when demand is high. This helps to balance out the supply and demand of electricity on the grid, which is essential for maintaining a stable and reliable power supply. Additionally, energy storage systems can also help to smooth out fluctuations in the generation of renewable energy sources, such as wind and solar power, which can be intermittent and unpredictable. Energy storage systems ensure that there is always a consistent supply of electricity available to meet demand, even when the weather is not cooperating.

To enable energy storage systems to operate reliably they need to be able to whitstand abnormal operation conditions, such as for example the conditions during a short circuit fault. Energy storage systems can also be designed with redundant components and other protective features to reduce the risk of short circuits. Alternatively, the components can be overdesigned in terms of breaking capabilities so they can withstand greater electrical, thermal or mechanical shocks in significantly larger amount of time. For example, some systems may have multiple energy storage devices connected in parallel, so that if one device fails, the others can continue to operate and provide power to the grid. One common approach is to use protective devices, such as fuses or circuit breakers, which are designed to quickly interrupt the flow of electricity in the event of a short circuit. These devices can help to prevent the short circuit from spreading and causing further damage to the system. The devices can be used both to disconnect the full energy storage system and to disconnect just a part of it.

However, the existing techniques for disconnecting and protecting the energy storage system often are too complex and not cost-efficient enough. Furthermore, the existing protection systems have limited application and many energy storage systems need to permit short-term or long-term loss of availability of energy storage devices.

### Summary

In view of the above, it is an object of the present disclosure to provide an improved energy storage segment for an energy storage system.

It is also an object of the present disclosure to provide an energy storage segment with an improved protective and bypass circuit which can reduce the short-term and long-term loss of availability of part of the energy storage system.

A further object is to provide an energy storage segment with a higher reliability and availability.

An object of the present disclosure is also to provide a more cost-efficient energy storage system.

To achieve at least one of the above objects, and also other objects that will be evident from the following description, an energy storage segment defined in claim 1 is provided according to the present disclosure. Preferred variants of the energy storage segment will be evident from the dependent claims.

More specifically, there is provided, according to a first aspect of the present disclosure, an energy storage segment for an energy storage system, which energy storage segment comprises a first terminal, a second terminal, and a plurality of energy module circuits connected in parallel between a first busbar and a second busbar. The second busbar is connected to the second terminal. Each energy module circuit comprises an energy storage module and a module switch connected in series. A first half bridge switch unit is connected between the first terminal and the first busbar and in series with the plurality of energy module circuits, and a second half bridge switch unit is connected between the first and second terminals.

The first half bridge switch unit and the second half bridge switch unit together with each module switch are advantageous as they may provide a safe and uninterruptable operation of the energy storage system. If a fault, for example a short circuit fault, occurs in the energy storage segment, the first half bridge switch unit, the second half bridge switch unit and the module switches are able to isolate the fault while still keeping the availability of the energy storage system. Each module switch is able to disconnect its respective energy storage module and thereby allowing the energy storage segment to keep operating while only switching one of the energy storage modules off.

The first half bridge switch unit and the second half bridge switch unit are advantageous as they are able to disconnect the full energy storage segment if the fault is not isolated by just disconnecting one energy module circuit or in a case where the fault happens between the first or second half bridge switch unit and the energy module circuit. The first half bridge switch unit and the second half bridge switch unit may also be advantageous as they are able to protect the full energy storage segment if the external fault happens between first and second terminal or at one of them. These two operations allow the energy storage system to bypass either a complete energy storage segment or one or more energy module circuits. The bypassing can be made while maintaining a continuous current flow in the part of the energy storage system which is unaffected by the fault.

This switching operation may also be used when the energy storage system is charging. Through the first half bridge switch unit and the second half bridge switch unit the energy storage system is able to decide which energy storage segments that should be charged at the moment. Through each module switch the energy storage segment can enable charging of the energy storage module down to an individual level. This may allow for a smooth charging of the energy storage system where it can be controlled at two levels, where the first level is for each energy storage segment and the second level is for each energy storage module. Thereby, the energy storage system is able to charge one energy storage module at the time if wanted, or the amount of energy storage modules required, to keep the input voltage and the input current at healthy levels in each energy storage module.

The first half bridge switch unit, the second half bridge switch unit and the module switches may also be advantageous as they provide the possibility to balance the energy between different energy storage segments in the energy storage system. The parallel energy module circuits within each energy storage segments may also be advantageous as they provide the possibility to balance the energy between themselves.

The energy storage segment may be advatangeous as it provides the possibility to handle energy storage system faults which generates high currents, e.g., a short-circuit between dc poles of whole ESS, coordinated triggering and operation of each energy storage segment may allow the energy storage system to handle such fault. The coordinated triggering and operation of each energy storage segment provides a distributed protection of the energy storage system.

Furthermore, the manufacturing and maintenance costs of the energy storage system may be reduced as the number of switch circuits and bypassing circuits, such as the first half bridge switch unit, the second half bridge switch unit and each module switch, are low.

Even further, the energy storage segment may be advantageous as it is easy to scale which adds flexibility to the energy storage system design.

The first half bridge switch unit may comprise a first segment switch and a first diode unit connected in parallel, and the second half bridge switch unit may comprise a second segment switch and a second diode unit connected in parallel.

The first segment switch and the second segment switch may be advantageous as they provide the controllability described above.

The diode units may be advantageous as they only allow current flow in one direction, which can protect sensitive electronic components from damage due to reverse currents or voltage spikes. Additionally, they provide for smooth switching when it is necessary to bypass the energy storage segment.

The first diode unit may be configured to allow current to flow from the first terminal to the second terminal, and the second diode unit may be configured to allow current to flow from the second terminal to the first terminal.

Thereby, the first and second diode units may protect the energy storage system from fault currents if a fault occurs in an energy storage segment. The first diode unit and the second diode unit may also prevent arcing when its respective segment switch is opened. For example, when the first segment switch is opened to break the current, the current may flow through the diode and therefore there will be no arcing. The first diode unit and the second diode unit may also help to prevent damaging voltages when a fault occurs.

Each energy storage module may comprise a plurality of energy storage cells connected in series and/or parallel.

It may be advantageous that each energy storage module is provided with a plurality of energy storage cells that are connected in series and parallel as it will increase the flexibility of how the energy storage system is designed. By connecting several energy storage segments in series, the voltage provided by the energy storage system may be varied to be adapted to the voltage of the transmission system. With several energy storage segments in series, it is also possible to design the energy storage system to be applicable in different designs of transmission systems. As an example, the energy storage system may be designed with the number of energy storage segments needed in series as a branch to achieve the required voltage rating. To adapt the energy storage system to the energy storage capacity requirements of the transmission system there may be several branches with energy storage segments in series connected in parallel.

The energy storage cells may have cell switches that allow each energy storage cell to be operated.

Each module switch may be one from a group of switches consisting of: electromagnetic contactor, mechanically operated switch, power electronic device, vacuum switch, fuse and pyro switch.

Each module switch may interrupt an electrical circuit or create a connection in an electrical circuit.

Each segment switch may be one from a group of switches consisting of: electromagnetic contactor, mechanically operated switch, power electronic device, vacuum switch, fuse and pyro switch.

Each segment switch may interrupt an electrical circuit or create a connection in an electrical circuit.

It should be noted that there could be any possible combination of switches that allows the desired operation of the energy storage segment. It should be stressed that it may both be irreversible, non-resettable switches (only for a single closure/opening), e.g., pyro switch, or fuse,or resettable switches, e.g., an electromagnetic contactor, a mechanically operated switch, or power electronic devices (e.g., IGBT, MOSFET).

As an example the first segment switch and the second segment switch may be pyro switches that are combined with the respective anti-parallel diode unit. This design may be advantageous as it allows active control the current flow, through bypassing and breaking the energy storage segment while the construction and operational costs may be kept low. Also this combination may be more reliable in comparison with power electronic based solutions.

According to a second aspect, there is provided an energy storage system comprising a plurality of energy storage segments according to the first aspect and a control unit configured to control each module switch, the first half bridge switch unit and the second half bridge switch unit.

The control unit that is configured to control each module switch, the first half bridge switch unit and the second half bridge switch unit may be advantageous as it provides a point where all parts of the energy storage system may be controlled which may provide a smarter control of the energy storage system.

The control unit may further enhance a coordinated protective disconnection of all or a selected group of the energy storage segments and the energy storage module in the energy storage system to prevent any high-hazard failures in the energy storage circuit on the system level, which may be potentially followed by fires and explosions.

The control unit may be connected to other components of a power grid in which the energy storage system operates. By connecting the control unit to other components it may allow control of the energy storage system based on information from the power grid. Such information may for example be power balance, voltage level or current levels.

The control unit may be able to collect necessary information about the status of each energy storage module and each energy storage segment and may be able to identify a fault once it occurs. Once the fault is identified the control unit can adequately implement one of the disconnection/bypassing methods below to maximize the availability of the energy storage system with maintained safety.

The control unit may be configured to bypass or connect one of the plurality of energy storage segments or one of the energy module circuits.

To allow the control unit to bypass or connect each energy storage segment and each energy storage module may be advantageous as it allows the control unit to monitor an operation state and status of each energy storage segment and each energy storage module. It may for example monitor the state of charge of each energy storage segment and each energy storage module. Thereby, the control unit is able to control which energy storage segments and which energy storage modules that should operate based on the monitored operation state and status, both during charge and discharge. This may further improve the smooth charging of the energy storage system.

The control unit may be implemented in a distributed hardware to allow the control unit to be united with a communication network. The control unit may be a plurality of control units. The plurality of control units may be responsible for different tasks and communicate with each other. In other words, there could be one control unit that monitors and one that is responsible for the control of the switches.

According to a third aspect, there is provided a method for controlling an energy storage system according to the second aspect, the method comprises bypassing an energy storage segment or an energy storage module and connecting an energy storage segment or an energy storage module, by controlling at least one of the module switches, the first half bridge switch and the second half bridge switch.

To be able to bypass one of the energy storage segments or one of the energy storage modules may be advantageous as it allows the energy storage system to be controlled such that only the required number of energy storage segments or energy storage modules are connected or disconnected to/from the energy storage system. The control may in other words be performed irrespectively of direction of the current flow.

The method may further comprise monitoring a status of each energy storage module with the control unit, and determining the number of energy storage modules available for charge or discharge.

It may be advantageous to monitor the status of each energy storage module as it provides a good overview of the health of the energy storage system. By knowing the number of energy storage modules that are available for both charge and discharge operation the current possibility for the energy storage system to support a power grid may be predicted in advance. It may also provide the possibility to take preventive measures if to many of the energy storage modules are unavailable. This may provide the power grid operator with a better control and predictability of the operation in the power grid. The determination of which energy storage modules are available may be done through different parameters, such as the state of charge, power status or the functionality of the energy storage module.

The method may further comprise, at the occurrence of a failure at an energy storage segment, operating at least one of the module switches and the first and second half bridge switch units of the energy storage segment in order to bypass at least one of the energy storage modules and the energy storage segment, wherein the method is configured to operate a minimum number of the module switches and the first and second half bridge switch units.

If a fault occurs in the energy storage segment it may be advantageous that each module switch and the first and second half bridge switch units bypass either the complete energy storage segment or a single energy storage module. By operating only a minimum number of the module switches and the first and second half bridge units as much as possible of the energy storage segment or energy storage system may keep operating. Therefore, the up time of the energy storage system may be further increased.

The method may further comprise deciding, based on the number of available energy storage modules, if the complete energy storage segment or at least one unavailable energy storage module should be bypassed.

If too many of the energy storage modules are unavailable at the same time the energy storage segment will not be able to provide the required current flow. In such case it may be advantageous to bypass the complete energy storage segment. Thereby, the control unit of the energy storage system have the possibility to bypass the complete energy storage segment if needed and to bypass only one energy storage module if possible. This may further enhance the availability of the energy storage segment and therefore also the energy storage system. When it is possible to bypass only a single energy storage module it may allow to reduce the number of energy storage segments in the energy storage system.

The method may further comprise controlling a root mean square current that passes through each energy storage module.

By controlling the root mean square current that passes through each energy storage module it may be possible to perform a soft charging, also referred to as gradual charging, of the energy storage system. By utilizing coordinated switching among all energy storage segments in the energy storage system the charge and discharge currents may be controlled.

The method may further comprise at the occurrence of a failure at an energy storage segment, identifying the type of fault and determining the fault location.

It may be advantageous to identify which type of fault and the location of the fault as it may support the control unit in which switches that should be switched. This may result in that effects from the fault may be mitigated quicker.

Effects and features of the second and third aspects may be largely analogous to those described above in connection with the first aspect. Embodiments mentioned in relation to the first aspect may be at least largely compatible with the second and third aspects. It is further noted that the present disclosure relates to all possible combinations of features unless explicitly stated otherwise.

A further scope of applicability of the present disclosure will become apparent from the detailed description given below. However, it should be understood that the detailed description and specific examples, while indicating preferred embodiments of the disclosure, are given by way of illustration only, since various changes and modifications within the scope of the disclosure will become apparent to those skilled in the art from this detailed description.

Hence, it is to be understood that the present disclosure is not limited to the particular component parts of the device described or steps of the methods described as such device and method may vary. It is also to be understood that the terminology used herein is for purpose of describing particular embodiments only, and is not intended to be limiting.

### Brief description of the Drawings

The present disclosure will by way of example be described in more detail with reference to the appended drawings, which show example embodiments of the disclosure.
- Fig. 1: illustrates a circuit of a first embodiment of an energy storage segment.
- Fig. 2: illustrates a circuit of a second embodiment of an energy storage segment.
- Fig. 3: illustrates an overview of an energy storage system.
- Fig. 4: illustrates a method for controlling an energy storage system.
- Fig. 5a-5d: illustrates a operation sequence for clearing a short-circuit at an energy storage module.
- Fig. 6a-6b: illustrates an operation sequence for clearing an external terminal short-circuit fault.

### Detailed desription

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

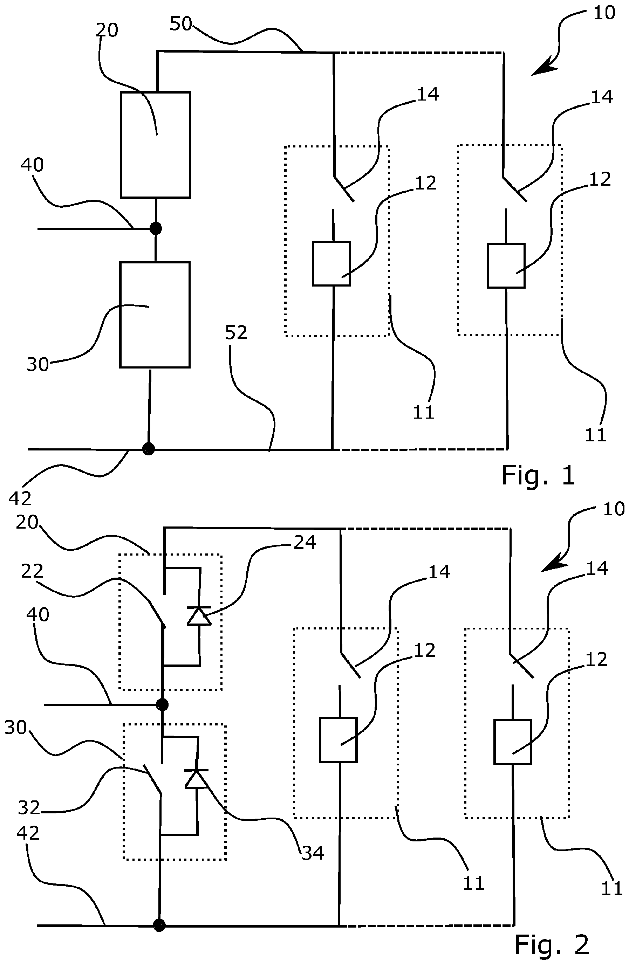

In Fig. 1 a first embodiment of an energy storage segment 10 for an energy storage system 1 is illustrated. The energy storage segment 10 comprises a first terminal 40 and a second terminal 42. The first terminal 40 and the second terminal 42 connect the energy storage segment 10 to the remaining part of the energy storage system 1. The energy storage segment 10 comprises a plurality of energy module circuits 11 connected in parallel with each other between a first busbar 50 and a second busbar 52. The first busbar 50 and second busbar 52 are partly represented by dotted lines to indicate that any number of energy module circuits 11 may be installed between the two illustrated energy module circuits 11. The energy module circuit 11 is the circuit part that is connected in parallel with other energy module circuits 11 to provide the energy storage module 10. The energy module circuit 11 may be provided with different components to provide different functions. However, in Fig. 1 each energy module circuit 11 comprises an energy storage module 12 and a module switch 14 connected in series. Each energy storage circuit 11 provides storage capacity through the respective energy storage module 12. The energy storage modules 12 are connected with each other in parallel. The module switch 14 provides the possibility to disconnect and connect each energy module circuit 11. Depending on the type of switch it may in some embodiments only be able to disconnect the energy module circuit 11. The second busbar 52, to which the energy module circuits 11 are connected, is connected to the second terminal 42.

The energy storage segment 10 further comprises a first half bridge switch unit 20, which is connected between the first terminal 40 and the first busbar 50 and in series with the plurality of energy module circuits 11, and a second half bridge switch unit 30, which is connected between the first terminal 40 and the second terminal 42. The first half bridge switch unit 20 and the second half bridge switch unit 30 allows the energy storage system 1 to bypass the energy storage segment 10.

The first half bridge switch unit 20 and the second half bridge switch unit 30 together with each module switch 14 provide the energy storage segment 10 with a switching structure that allows the energy storage system 1 to be operated both at an energy storage segment level and at an energy storage module level. The switching structure allows the energy storage system 1 to isolate faults such as for example short circuits, open circuits, and other abnormal operation of the energy storage module 12 that may for example be aged energy storage modules 12. By isolating a fault the parts of the energy storage system 1 that are not affected by the fault may keep operating. The first half bridge switch unit 20, the second half bridge switch unit 30 and each module switch 14 may also be used for operating the charging of the energy storage segment 10 and, more particularly, each energy module circuit 11, which provides a soft charging. This also provides a balancing function between energy storage segments 10 and internally between parallel energy storage modules 12. The balancing function may be performed both while charging and discharging the energy storage system 1.

Turning to Fig. 2, a second embodiment of the energy storage segment 10 is illustrated. The first terminal 40, the second terminal 42, and each energy storage circuit 11 are connected as mentioned in connection to Fig. 1. The first half bridge switch unit 20 comprises a first segment switch 22 and a first diode unit 24 connected in parallel. The second half bridge switch unit 30 comprises a second segment switch 32 and a second diode unit 34 connected in parallel. The first segment switch 22 and the second segment switch 32 provide the switching functionality described in connection with Fig. 1. The first diode unit 24 is connected such that it allows current flow from the first terminal 40 to the second terminal 42. The second diode unit 34 is connected such that it allows current flow from the second terminal 42 to the first terminal 40. The first diode unit 24 and the second diode unit 34 are used to protect the energy module circuits 11 and the other parts of the energy storage system 1 from damage that may occur due to reverse currents at a short circuit fault or voltage spikes. The first diode unit 24 and the second diode unit 34 also create continuous current flow paths during the commutation of bypassing the energy storage circuit 11, so no interruption of the string current is required. The first diode unit 24 and the second diode unit 34 may also prevent arcing when its respective segment switch 22, 32 is opened. For example, when the first segment switch 22 is opened to break the current, the current may flow through the first diode unit 24 and therefore there will be no arcing.

Each module switch 14, the first segment switch 22 and the second segment switch 32 which can interrupt an electrical circuit or create a connection in an electrical circuit and for example may be one from a group of switches consisting of: electromagnetic contactor, mechanically operated switch, power electronic device, vacuum switch, fuse, and pyro switch. It should be noted that there could be any possible combination of switches that allows the desired operation of the energy storage segment 10. It should be stressed that it may both be irreversible, non-resettable switches (only for a single closure/opening), e.g., pyro switch, and fuse, or resettable switches, e.g., an electromagnetic contactor, mechanically operated switch, and power electronic devices (e.g., IGBT, MOSFET). A resettable switch may be advantageous to use for some energy storage systems 1 as it provides higher controllability while a non-resettable switch may be advantageous for other energy storage systems 1 as it may be more cost-efficient. As an example, the first segment switch 22 and the second segments switch 32 may be pyro switches that are combined with the respective anti-parallel diode unit 24, 34.

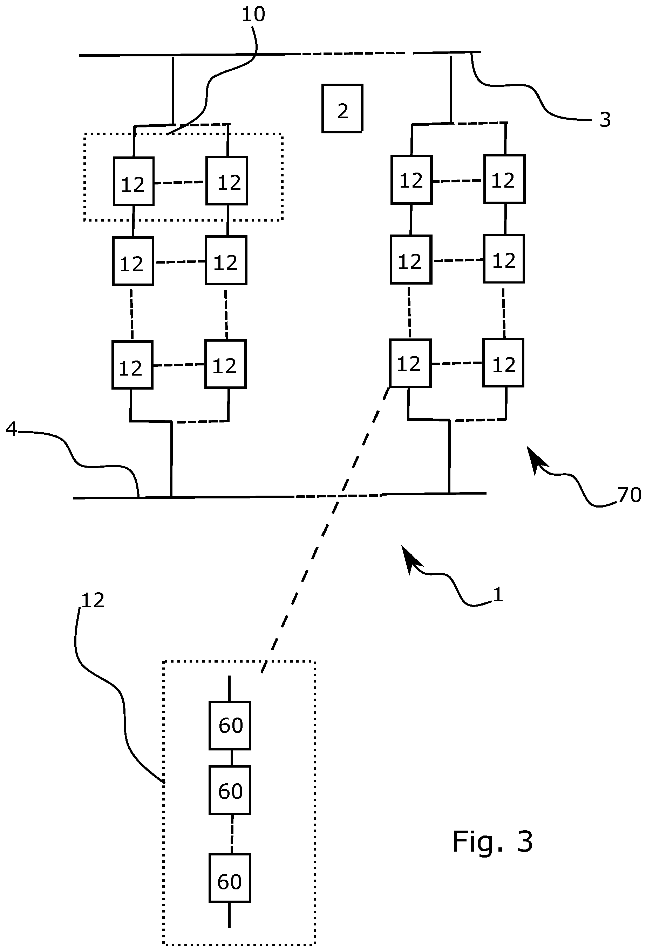

Turning to Fig. 3, an energy storage system 1 is illustrated. In Fig. 3 the dotted lines indicates that there may be more duplicates of the component inbetween. The energy storage system 1 comprises a plurality of energy storage strings 70 that are connected in parallel to each other. Each energy storage string 70 comprises a plurality of energy storage segments 10, which are connected in series with each other. Each energy storage segment 10 comprises a plurality of energy storage modules 12, which are connected in parallel to each other. In the enlarged view an energy storage module 12 is illustrated. Each energy storage module 12 comprises a plurality of energy storage cells 60 connected in series. In Fig. 3 only energy storage cells 60 connected in series are shown. However, it is possible that each energy storage module also comprises energy storage cells 60 connected in parallel. As an example, there may be four columns with twenty-two energy storage cells 60 connected in series and these four columns are connected in parallel to each other such that it is in total eighty-eight energy storage cells 60 in one energy storage module 12. As an example, the energy storage system 1 may be designed with a number of energy storage segments needed in series as a branch to achieve the required voltage rating and with a number of branches in parallel to achieve the required energy capacity.

The energy storage system 1 further comprises a control unit 2 that is configured to control each module switch 14, each first half bridge switch unit 20 and each second half bridge switch unit 30. The control unit 2 may be used to coordinate a protective disconnection sequence by, for instance, bypassing or connecting one of the plurality of energy storage segments 10 or one of the plurality of energy module circuits 11. The control unit 2 can be used to monitor an operation state and status of each energy storage segment 10 and each energy storage module 12. It may for example monitor the state of charge of each energy storage segment 10 and each energy storage module 12. Thereby, the control unit 2 is able to control which energy storage segments 10 and which energy storage modules 12 that should operate based on the monitored operation state and status, both during charge and discharge. In the case of a fault, the control unit 2 is also able to determine the number of energy storage modules 12 available for use from the energy storage segment 10 and thereafter deciding if the energy storage segment 10 should keep operating with the remaining energy storage modules 12 in the energy storage segment 10 or if the complete energy storage segment 10 should be bypassed.

The control unit 2 may be connected to other components of a power grid in which the energy storage system 1 operates. By connecting the control unit 2 to other components it may allow control of the energy storage system 1 based on information from the power grid. Such information may for example be power balance, voltage level or current levels. The control unit 2 may be able to collect necessary information about the status of each energy storage module 12 and each energy storage segment 10 and may be able to identify a fault once it occurs. Once the fault has been identified the control unit can adequately implement one of the disconnection/bypassing methods below to maximize the availability of the energy storage system with maintained safety.

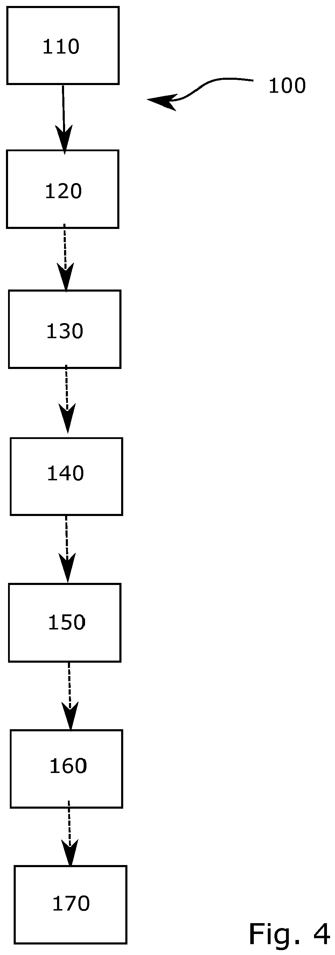

Turning to Fig. 4 a method 100 for controlling an energy storage system 1 is illustrated. The method 100 comprises bypassing 110 an energy storage segment 10 or an energy storage module 12 and connecting 120 an energy storage segment 10 or an energy storage module 12, by controlling at least one of the module switches 14, the first half bridge switch 22 and the second half bridge switch 32. This allows the control unit 2 of the energy storage system 1 to control the number of energy storage segments 10 and energy storage modules 12 that are bypassed or connected and may therefore be controlled to satisfy the requirements of the power grid to which the energy storage system 1 may be connected.

With reference to Fig. 4 some alternative steps are illustrated as well and represented by dotted arrows. These steps can be part of the method separately or in combination with each other. The method may comprise monitoring 130 a status of each energy storage module 10 with the control unit 2 and determining 140 the number of energy storage modules 10 available for charge or discharge. Thereby the energy system will have knowledge of the current status of each energy storage module 10. The determination of which energy storage modules are available may be done through different parameters, such as the state of charge, power status or the functionality of the energy storage module.

The method 100 may further comprise, at the occurrence of a failure at an energy storage segment 10, identifying the type of fault and determining the fault location. The step of identifying may be performed by connecting a plurality of sensors for detecting suitable system parameters, such as currents and voltages, at different positions in the energy storage system, and connecting the plurality of sensors to the control unit 2.

The method 100 may further comprise, at the occurrence of a failure at an energy storage segment 10, operating 150 at least one of the module switches 14 and the first 20 and second 30 half bridge switch units of the energy storage segment 10 in order to bypass at least one of the energy storage modules 12 and the energy storage segment 10, wherein the method 100 is configured to operate a minimum number of the module switches 14 and the first half bridge switch unit 20 and the second half bridge switch unit 30.

The method 100 may further comprise deciding 160, based on the number of available energy storage modules 12, if the complete energy storage segment 10 or at least one unavailable energy storage module 12 should be bypassed. If too many of the energy storage modules 12 are unavailable at the same time, the energy storage segment 10 will not be able to provide the required current. In such case it may be advantageous to bypass the complete energy storage segment 10. Thereby, the control unit 2 of the energy storage system 1 have the possibility to bypass the complete energy storage segment 10 if needed and to bypass only one energy storage module 12 if possible.

The method 100 may further comprise controlling 170 a root mean square current that passes through each energy storage module 12. By controlling the root mean square current the passes through each energy storage module 12 it may be possible to perform a soft charging, also referred to as gradual charging, of the energy storage system 1.

The method 100 may further comprise balancing energy between different energy storage segments 10 and /or parallel energy storage modules 12 within each energy storage segment 10.

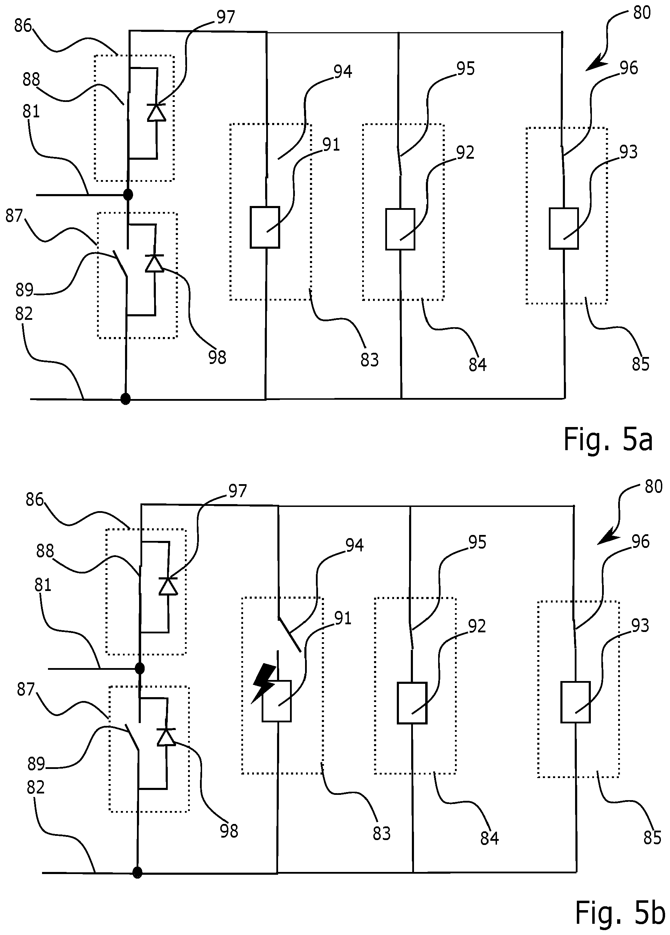

An example of how the present method operates in a fault situation will now be described with reference to Fig. 5a-5d. The energy storage segment 80 comprises a first, second and third energy module circuits 83, 84, 85, and first and second half bridge switch units 86, 87. Each energy module circuit comprises an energy storage module 91, 92, 93 and a module switch 94, 95, 96. The first half bridge switch unit 86 comprises a first segment switch 88 and a first diode unit 97. The second half bridge switch unit 87 comprises a second segment switch 89 and a second diode unit 98. At normal operation each module switch 94, 95, 96 and the first segment switch 88 are closed and the second segment switch 89 is open. This allows the main current to flow from the first terminal 81, through the energy storage segment 80 and out of the second terminal 82. This will further be referred to as normal operation with positive current direction and is illustrated in Fig. 5a.

In Fig. 5b, it is assumed that a short-circuit occurs in a first energy module circuit 83 where the fault happens internally in relation to the module switch 94. When the short-circuit is detected by control equipment in the energy storage system 1, the module switch of the energy module circuit where the fault occurs will open, in this case the module switch 94 of the first energy module circuit 83. If this step would isolate the fault and if the postfault conditions allow the energy storage segment 80 to operate with reduced capacity, no further actions are needed. With no further action is inhere meant that from the rest of the system point of view the fault is not longer present so it can continues operation. On the other hand the faulty energy storage module 12 can still experiece electrical, mechanical, thermal stress caused by the fault. In this case other actions are needed to minimize the risk of hazardous situation in relation with the failed module. Thus, in some cases only the faulty energy module circuit 83 is required to be bypassed to continue the operation of the energy storage segment 80. However, if fault conditions do not allow the energy storage segment 80 to operate with reduced capacity the whole energy storage segment 80 is required to be bypassed.

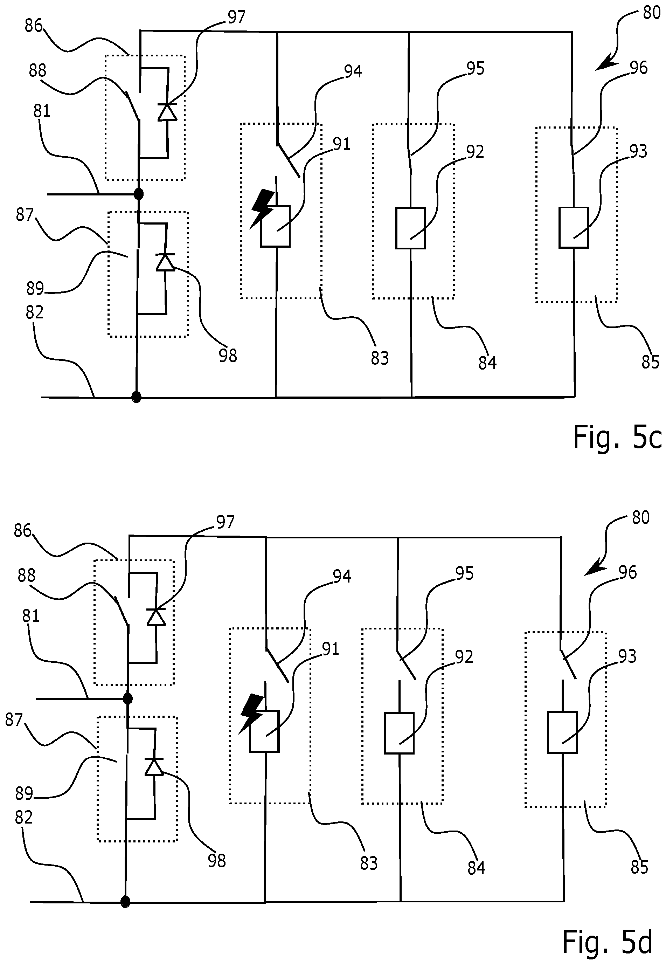

In Fig. 5c it is illustrated when the complete energy storage segment 80 is bypassed. The first step is opening the first segment switch 88. When the first segment switch 88 is opened the first diode unit 97 still conducts which prevents arcing over the first segment switch 88. Thereafter, the second segment switch 89 is closed, providing the current with a way to bypass the complete energy storage segment 80. At this stage, the remaining module switches 92, 93 may be opened, as can be seen in Fig. 5d. The module switches 92, 93 may also remain closed and the energy storage segment 80 will be in hot standby.

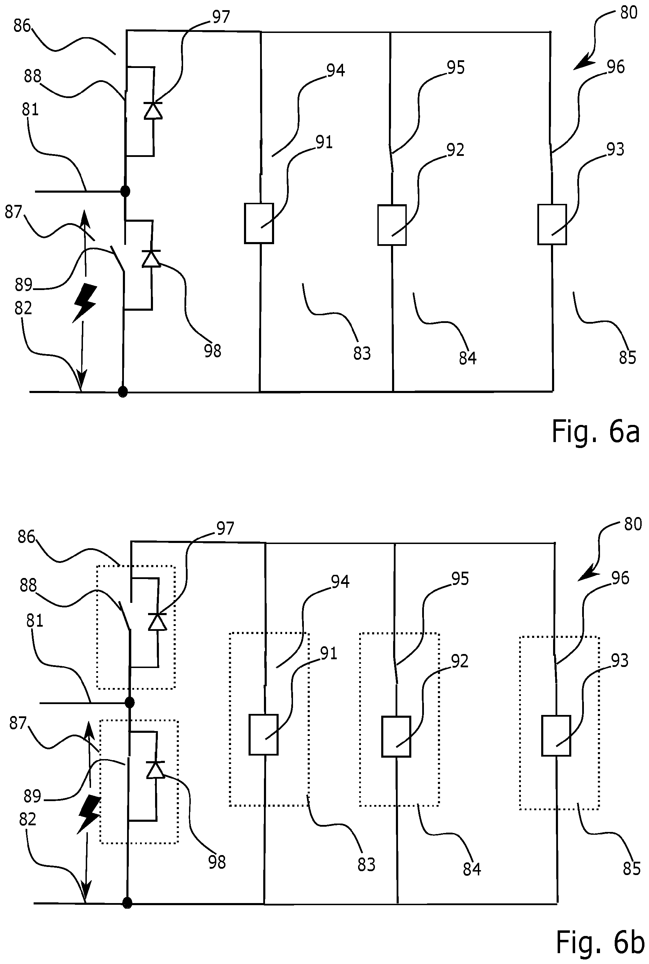

Turning to Fig. 6a-6b another type of fault is illustrated. The other type of fault is an external terminal short-circuit. Before the fault occurs the energy storage segment 80 is in normal operation which was described in connection with Fig. 5a. In Fig. 6a, the short-circuit between the terminals 81, 82 has occurred. This kind of fault may be cleared by bypassing the complete energy storage segment 80. This is done by first closing the second segment switch 89 and allowing the current to flow and skip the energy storage segment 80. Then, the first segment switch 88 is opened in a similar way as described with connection to Fig. 5c. This sequence is illustrated in Fig. 6b. If the fault is not cleared by these operations, the fault can be cleared by opening each of the module switches 94, 95, 96 which is not illustrated in any figure. However, the switches of the energy storage segment 80 would have a similar configuration as the switches in Fig. 5d.

It is understood that Fig. 5a-5d and Fig. 6a-6b are only two examples of faults that may occur at the energy storage segment 80. There may for example be faults when the current has a negative direction, there may be open-circuit faults and other types of abnormal operation that must be treated as a fault so the bypassing/disconnection of some parts of the energy segment circuit must be activated. With guidance of these two examples the person skilled in the art would understand how to operate the switches to clear other types of fault that may occur.

The person skilled in the art realizes that the present disclosure by no means is limited to the preferred embodiments described above. On the contrary, many modifications and variations are possible within the scope of the appended claims. Additionally, variations to the disclosed embodiments can be understood and effected by the skilled person in practicing the claimed invention, from a study of the drawings, the disclosure, and the appended claims

## Claims

1. An energy storage segment (10) for an energy storage system (1), the energy storage segment comprising:
a first terminal (40) and a second terminal (42),
a plurality of energy module circuits (11) connected in parallel between a first busbar (50) and a second busbar (52),
wherein the second busbar (52) is connected to the second terminal (42),
wherein each energy module circuit (11) comprises an energy storage module (12) and a module switch (14) connected in series,
a first half bridge switch unit (20) connected between the first terminal (40) and the first busbar (50) and in series with the plurality of energy module circuits (12),
a second half bridge switch unit (30) connected between the first terminal (40) and the second terminal (42).

2. The energy storage segment (10) according to claim 1, wherein the first half bridge switch unit (20) comprises a first segment switch (22) and a first diode unit (24) connected in parallel, and
wherein the second half bridge switch unit (30) comprises a second segment switch (32) and a second diode unit (34) connected in parallel.

3. The energy storage segment (10) according to claim 2, wherein the first diode unit (24) is configured to allow current to flow from the first terminal (40) to the second terminal (42), and
wherein the second diode unit (34) is configured to allow current to flow from the second terminal (42) to the first terminal (40).

4. The energy storage segment (10) according to any one of the preceding claims, wherein each energy storage module (12) comprises a plurality of energy storage cells (60) connected in series and/or parallel.

5. The energy storage segment (10) according to any one of the preceding claims, wherein each module switch (14) is one from a group of switches consisting of: electromagnetic contactor, mechanically operated switch, power electronic device, vacuum switch, fuse, and pyro switch.

6. The energy storage segment (10) according to any one of claims 2 to 6, wherein each of the first segment switch (22) and the second segment switch (32) is one from a group of switches consisting of: electromagnetic contactor, mechanically operated switch, power electronic device, vacuum switch, fuse, and pyro switch.

7. An energy storage system (1) comprising a plurality of energy storage segments (10) according to any one of claims 1 to 6, and
a control unit (2) configured to control each module switch (12), the first half bridge switch unit (22) and the second half bridge switch unit (32).

8. The energy storage system (1) according to claim 7, wherein the control unit (2) is configured to bypass or connect one of the plurality of energy storage segments (10) or one of the energy module circuits (11).

9. A method (100) for controlling an energy storage system according to claim 7, the method comprising:
bypassing (110) an energy storage segment (10) or an energy storage module (12), and
connecting (120) an energy storage segment (10) or an energy storage module (12), by controlling at least one of the module switches, the first half bridge switch and the second half bridge switch.

10. The method (100) according to claim 9, further comprising:
monitoring (130) a status of each energy storage module (12) with the control unit (2), and
determining (140) the number of energy storage modules (12) available for charge or discharge.

11. The method (100) according to claim 9 or 10, further comprising, at the occurrence of a failure at an energy storage segment, operating (150) at least one of the module switches and the first and second half bridge switch units of the energy storage segment in order to bypass at least one of the energy storage modules and the energy storage segment, wherein the method is configured to operate a minimum number of the module switches and the first and second half bridge switch units.

12. The method (100) according to claim 11, further comprising
deciding (160), based on the number of available energy storage modules (12), if the complete energy storage segment (10) or at least one unavailable energy storage module (12) should be bypassed.

13. The method (100) according to any one of claims 10 to 12, further comprising
controlling (170) a root mean square current that passes through each energy storage module.

14. The method (100) according to any one of claims 10 to 13, further comprising, at the occurrence of a failure at an energy storage segment (10), identifying the type of fault and determining the fault location.
